Europäisches Patentamt

European Patent Office

Office européen des brevets

(11) Numéro de publication: **0 221 608 B1**

# FASCICULE DE BREVET EUROPEEN

(45) Date de publication de fascicule du brevet: **07.01.93** (51) Int. Cl.⁵: **H03B 5/18**

(21) Numéro de dépôt: **86201875.1**

(22) Date de dépôt: **27.10.86**

(54) **Oscillateur hyperfréquence modulé linéairement en fréquence et à coefficient de surtension externe élevé.**

(30) Priorité: **29.10.85 FR 8516043**

(43) Date de publication de la demande:
**13.05.87 Bulletin 87/20**

(45) Mention de la délivrance du brevet:
**07.01.93 Bulletin 93/01**

(84) Etats contractants désignés:
**DE FR GB IT SE**

(56) Documents cités:
**US-A- 4 310 809**

**1978 IEEE MTT-S INTERNATIONAL MICROWA-VE SYMPOSIUM DIGEST, 27-29 juin 1978, Ottawa, pages 145,146; R.M. RECTOR et al.: "A 1.0 watt GaAs MESFET oscillator at X-band"**

(73) Titulaire: **TELECOMMUNICATIONS RADIOE-LECTRIOUES ET TELEPHONIOUES T.R.T.**
**88, rue Brillat Savarin**
**F-75013 Paris(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT SE**

(72) Inventeur: **Rudelle, Marie-Irène**
**SOCIETE CIVILE S.P.I.D. 209 rue de l'Univer-sité**
**F-75007 Paris(FR)**

(74) Mandataire: **Chaffraix, Jean et al**
**Société Civile S.P.I.D. 156, Boulevard Haus-smann**
**F-75008 Paris(FR)**

# Description

L'invention concerne un oscillateur hyperfréquence modulé linéairement en fréquence autour d'une fréquence centrale selon le préambule de la revendication 1.

L'oscillateur de l'invention fournit une puissance de sortie de 0,1 à 1 watt à une fréquence de travail de l'ordre de 4 GHz et trouve une application de manière générale dans tout système F.M. et en particulier dans des équipements tels que les sources de radioaltimètres ou de fusées de proximité, les systèmes autodirecteurs et les radars à longue portée. Dans ces diverses applications, une bonne linéarité de la caractéristique fréquence-tension de commande et une isolation élevée contre les brouillages sont exigées. Pour répondre à cette condition d'isolation, l'oscillateur doit avoir un fort coefficient de sustension externe.

Des oscillateurs hyperfréquence du genre mentionné dans le préambule sont connus par exemple du brevet des Etats-Unis d'Amérique No 4 310 809 qui décrit un dispositif à résistance négative réalisé à partir d'un transistor bipolaire et dont la variation de fréquence est commandée par des varactors placés en parallèle dans le circuit de modulation. Des oscillateurs de ce type, d'un usage courant dans le domaine des hyperfréquences, fournissent une faible puissance de sortie qui est ici de 10 mW à 8,5 GHz. Une méthode pour réduire la sensibilité aux influences extérieures d'un tel oscillateur consisterait à placer un isolateur à sa sortie.

Une autre méthode applicable à un oscillateur à forte puissance de type amplificateur bouclé par exemple, consisterait à placer à la sortie de cet oscillateur un atténuateur ou un coupleur directif, mais le Q externe ne serait augmenté que dans le rapport des puissances.

Le but de l'invention selon la revendication 1 est de fournir une méthode plus simple et plus économique pour réaliser une isolation élevée de l'oscillateur contre les brouillages. Une telle méthode est remarquable en ce que ledit transistor ayant un gain élevé et une forte puissance de sortie, l'oscillation est obtenue pour un mode de fonctionnement stable du transistor dans ladite plage de fréquence au moyen d'un réseau de rebouclage adaptant son entrée à sa sortie, ledit rebouclage étant obtenu en sortie de l'oscillateur à partir d'une ligne faiblement couplée par proximité à l'une des lignes dudit réseau de rebouclage de façon à réinjecter à l'entrée du transistor la majeure partie de la forte puissance disponible à sa sortie, le faible couplage ainsi réalisé et la directivité du coupleur d'une part, l'état de saturation du transistor d'autre part assurant à l'oscillateur un coefficient de surtension externe élevé.

Ladite diode à capacité variable permettant la modulation en fréquence et un condensateur fixe sont intercalés en série entre trois éléments de ligne dans un circuit de modulation monté en parallèle sur ledit réseau de rebouclage, une borne dudit condensateur étant reliée à un point du réseau de rebouclage à travers un premier élément de ligne et l'autre borne à la cathode de la diode à travers un deuxième élément de ligne, l'anode de la diode étant mise à la masse à travers un troisième élément de ligne, lesdits éléments de ligne étant déterminés pour optimiser la linéarité de la modulation de fréquence en fonction de ladite tension de commande.

L'invention sera mieux comprise à l'aide de la description suivante d'un mode de réalisation du dispositif de l'invention donné à titre d'exemple non limitatif, ladite description étant accompagnée de dessins qui représentent :

Figure 1 : le schéma de principe de l'oscillateur hyperfréquence conforme à l'invention.

Figure 2 : la vue d'ensemble d'une réalisation de l'oscillateur en technologie "micro-strip".

Figure 3 : les variations de la fréquence de l'oscillateur et de la puissance qu'il fournit en fonction de la tension de commande.

Figure 4 : la variation du Q externe de l'oscillateur en fonction de la tension de commande.

Figure 5 : la variation du Q externe en fonction de la tension de drain pour quelques valeurs de la tension de commande.

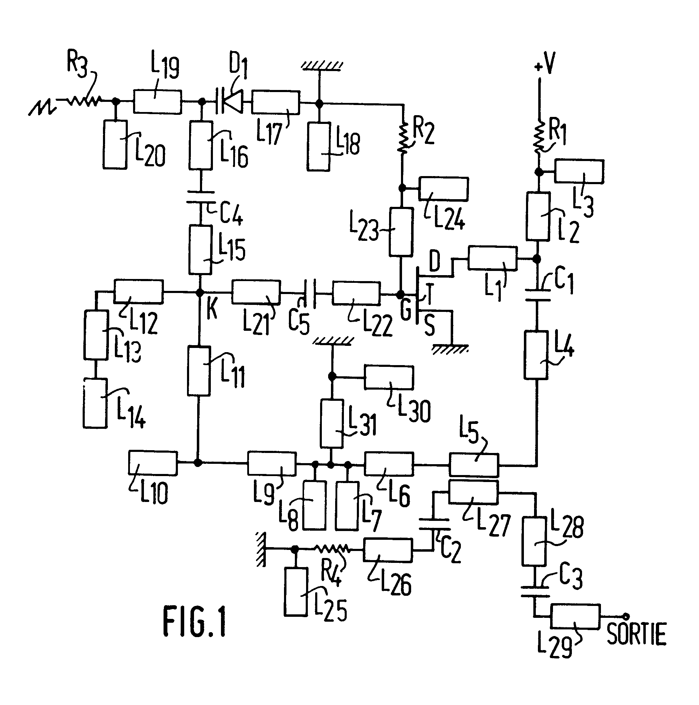

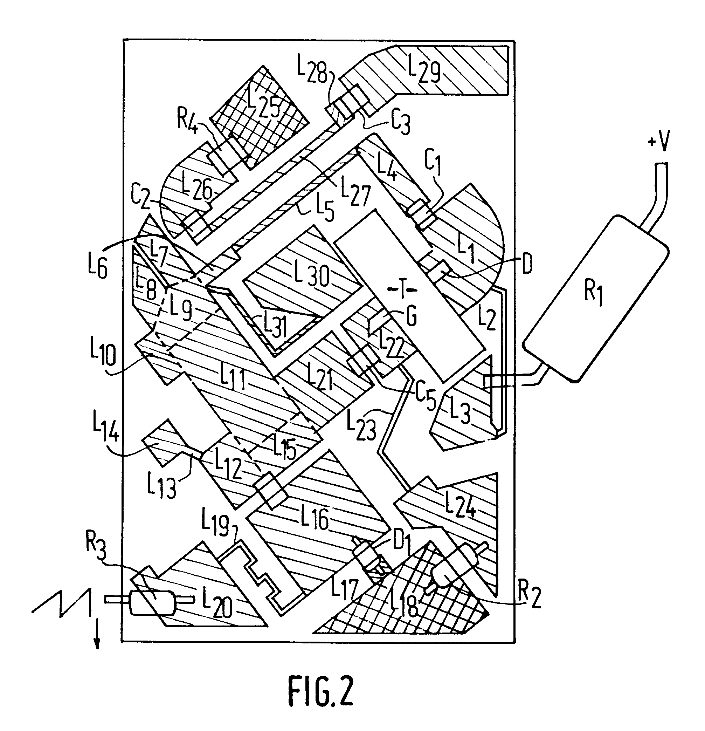

Les éléments correspondants sur les figures 1 et 2 seront désignés par les mêmes signes de référence.

L'oscillateur hyperfréquence de l'invention dont le schéma est représenté figure 1 est obtenu à partir d'un amplificateur bouclé comportant un transistor à effet de champ T monté en source commune S reliée directement à la masse et pouvant fournir une puissance de l'ordre de 500 mW.

L'adaptation entrée-sortie du transistor et l'oscillateur de circuit dans la bande de fréquence désirée sont déterminées par :

- la mise en série entre le drain D et la grille du transistor T de la ligne $L_1$, du condensateur $C_1$, des lignes $L_4$, $L_5$, $L_6$, $L_9$, $L_{11}$, $L_{21}$, du condensateur $C_5$ et de la ligne $L_{22}$.
- la mise en série des lignes $L_{12}$ et $L_{13}$ à partir du point d'interconnexion des lignes $L_{11}$ et $L_{21}$ ;
- les lignes ouvertes à une extrémité (appelées stubs dans la littérature anglo-américaine) $L_7$-$L_8$, $L_{10}$ et $L_{14}$ disposées respectivement aux interconnexions des lignes $L_6$ et $L_9$, $L_3$ et $L_{11}$ et à l'extrémité libre de la ligne $L_{13}$.

La modulation de fréquence linéaire est assurée par le circuit constitué par la mise en série de la ligne $L_{17}$, de la varicap $D_1$, de la ligne $L_{16}$, du

condensateur $C_4$, de la ligne $L_{15}$ et disposé en parallèle entre la masse et le point d'interconnexion K des lignes $L_{11}$ et $L_{21}$ sur le circuit d'adaptation entrée-sortie. Cette adaptation est réalisée de façon que le module du coefficient de réflexion par rapport à 50 ohms reste grand et varie peu en fonction de la fréquence et que la phase de ce coefficient de réflexion varie monotonement.

La puissance de sortie de l'oscillateur est prélevée à l'aide de la ligne $L_{27}$ placée le long de la ligne $L_5$.

La directivité du coupleur ainsi constitué est assurée par le circuit constitué par la mise en série entre la masse et la sortie de l'oscillateur de la résistance $R_4$, de la ligne $L_{26}$, du condensateur $C_2$, des lignes $L_{27}$ et $L_{28}$, du condensateur $C_3$ et de la ligne $L_{29}$, un stub $L_{25}$ étant disposé à l'extrémité de la résistance $R_4$ reliée à la masse.

La tension d'alimentation du drain (+ V) est amenée sur la ligne $L_1$ par l'intermédiaire de la résistance $R_1$ en série avec la ligne $L_2$, le stube $L_3$ étant disposé à l'interconnexion de $R_1$ et $L_2$.

La grille G est reliée à la masse à travers la ligne $L_{23}$ et la résistance $R_2$, le stub $L_{24}$ étant disposé à l'interconnexion de $L_{23}$ et de $R_2$.

Il faut remarquer qu'une tension d'alimentation de grille n'est pas nécessaire, le transistor s'autopolarisant lorsqu'il est fortement saturé.

La tension de commande de la varicap est appliquée sur la cathode de celle-ci à travers la mise en série de la résistance $R_3$ et de la ligne $L_{19}$, le stub $L_{20}$ étant disposé à l'extrémité de la ligne $L_{19}$ reliée à la résistance $R_3$.

La mise à la masse de l'anode est assurée par le stub $L_{18}$ disposé à l'interconnexion de la résistance $R_2$ et de la ligne $L_{17}$.

La linéarité résultant de ce type de modulation est définie comme la variation relative de pente de la caractéristique de variation de la fréquence de l'oscillateur en fonction de la tension de commande.

Dans l'exemple décrit une seule varicap $D_1$ est utilisée, mais on peut éventuellement améliorer les performances de linéarité en remplaçant le condensateur $C_4$ par une deuxième varicap placée tête-bêche avec la première et qui serait polarisée au moyen de la ligne $L_{31}$ connectée entre le point commun aux lignes $L_6$ et $L_9$ et du stub $L_{30}$ relié à la masse.

La figure 2 montre un exemple de réalisation de l'oscillateur.

Chaque ligne du schéma de la figure 1 représentée en traits hachurés est réalisée à l'aide d'une couche conductrice de longueur et de largeur bien définies déposées par sérigraphie sur une face d'une plaquette isolante. L'autre face en communication avec la précédente par l'intermédiaire de trous percés dans la plaquette est recouverte d'une couche conductrice uniforme qui constitue le plan de masse. Cette technologie est connue sous l'appellation de "strip-line" ou "microstrip" dans la littérature anglo-américaine.

Les lignes et stubs tels que $L_1$, $L_4$, $L_5$, $L_6$, $L_7$, $L_8$, $L_9$, $L_{10}$, $L_{11}$, $L_{12}$, $L_{13}$, $L_{14}$, $L_{21}$ et $L_{22}$ appartenant au circuit d'adaptation entrée-sortie du transistor T ont une largeur relativement élevée par rapport aux lignes telles que $L_2$, $L_{19}$, $L_{23}$ et $L_{31}$ qui ont une longueur de $\lambda/4$ et présentent une forte impédance pour assurer les amenées de courant au circuit ou les mises à la masse. Les lignes $L_5$ et $L_{27}$ du coupleur sont formées d'éléments de même longueur, de largeur faible par rapport à ladite longueur et suffisamment éloignés afin d'obtenir un faible couplage. Les plages du circuit réunies à la masse sont hachurées dans les deux sens. Les composants basse fréquence tels que les résistances d'alimentation $R_1$, $R_2$, $R_3$, $R_4$ et les condensateurs $C_1$, $C_2$, $C_3$, $C_4$, $C_5$ sont rapportés par soudures. Le transistor à effet de champ T est un transistor AsGa pouvant fournir une puissance de sortie de l'ordre de 500 mW.

Pour une tension de drain $V_{DS}$ de l'ordre de 8,5 V et un courant de drain $I_D$ de l'ordre de 300 mA, la puissance de sortie de l'oscillateur est de l'ordre de 40 mW.

L'encombrement de l'oscillateur est de 24 mm x 38 mm.

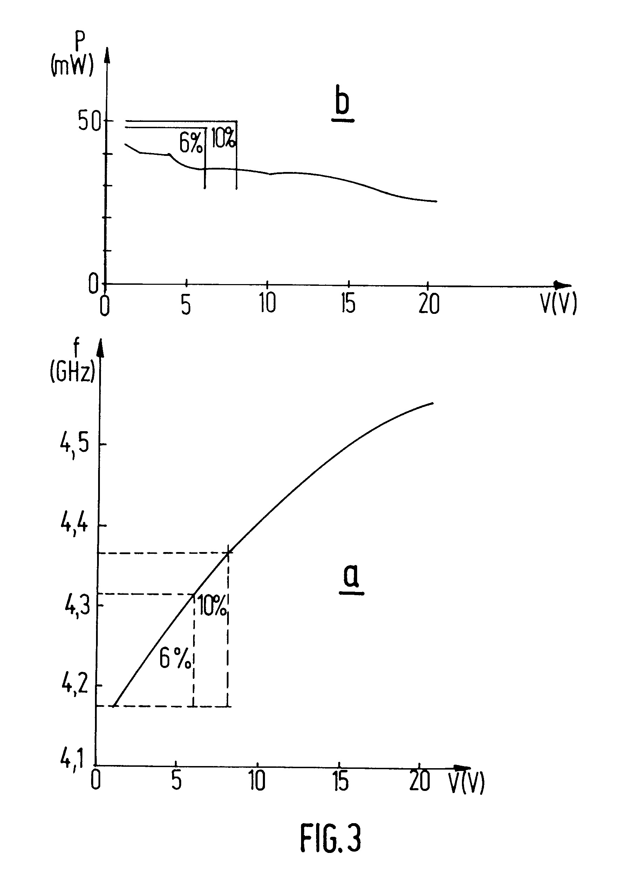

La figure 3a représente une caractéristique expérimentale de variation de la fréquence de sortie en fonction de la tension de commande de la varicap.

Autour d'une fréquence centrale de 4,3 GHz obtenue pour une tension de commande de la varicap de 8,5 V, l'examen de cette caractéristique met en évidence une bande de fréquence de 140 MHz modulée linéairement à moins de 6 % et une autre bande de fréquence de 190 MHz modulée linéairement à moins de 10 %, la linéarité étant évaluée selon sa définition la plus sévère comme le rapport des pentes maximale et minimale de la caractéristique dans la bande de fréquence considérée. Comme il a été indiqué ci-dessus, on peut élargir la zone de linéarité sans trop modifier le circuit en substituant au condensateur fixe $C_4$ une deuxième varicap.

La figure 3b donnant la variation expérimentale de la puissance de sortie de l'oscillateur en fonction de la même tension de commande montre que cette puissance est de l'ordre de 40 mW pour une tension de commande de l'ordre de 8,5 V. Cette puissance de sortie est dix fois plus faible que la puissance maximale disponible à la sortie d'un oscillateur bouclé à fort couplage utilisant le même transistor.

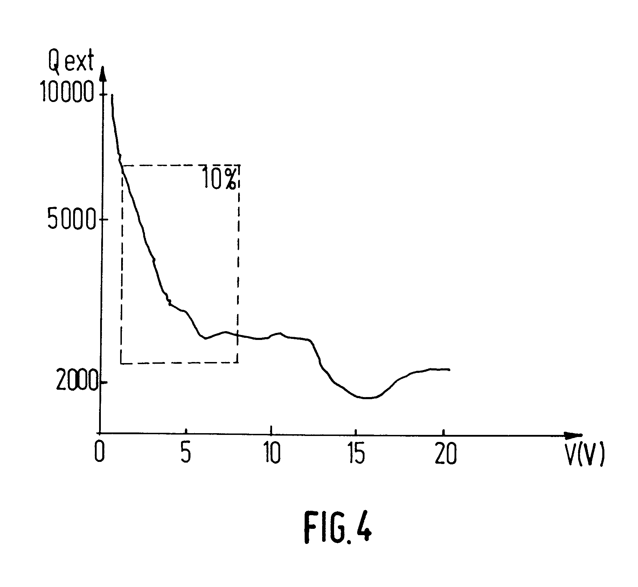

La figure 4 montre la variation du coefficient de surtension externe de l'oscillateur en fonction de la tension de commande. La valeur de ce coefficient de surtension est ici calculée à partir de la formule :

$$Q_{ext} = \frac{2f}{\Delta f} \sqrt{\frac{P_b}{P_{osc}}}$$

dans laquelle f est la fréquence de l'oscillateur, $P_{osc}$ sa puissance, $P_b$ la puissance du brouilleur utilisé et $\Delta f$ la bande de synchronisation correspondante de l'oscillateur.

La valeur de $Q_{ext}$ est en moyenne 70 fois plus élevée dans la bande de modulation utile que celle d'un oscillateur bouclé à fort couplage utilisant le même transistor et ayant une tension de drain $V_{DS}$ identique (8,5 V dans l'exemple cité).

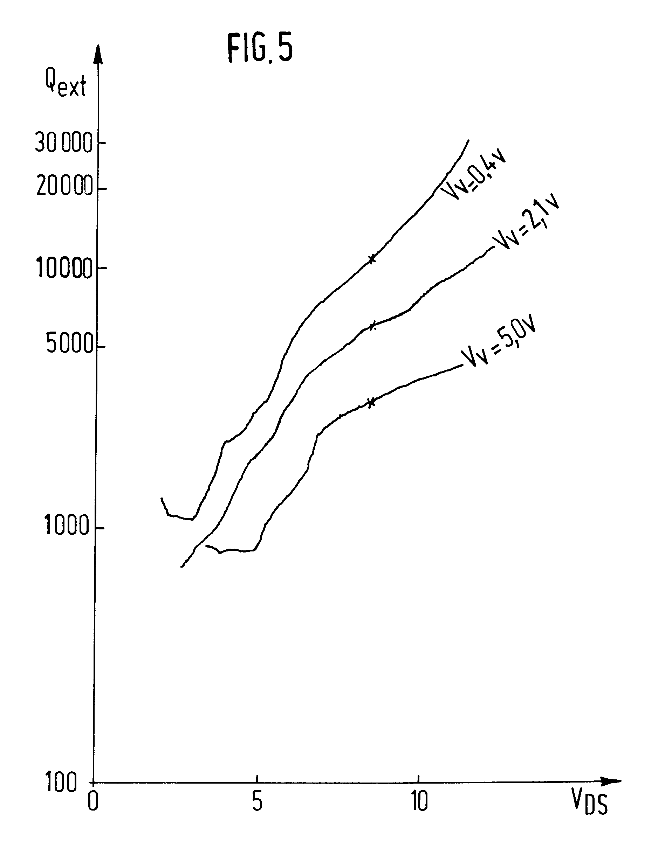

La figure 5 donne la variation de $Q_{ext}$ avec la tension de drain $V_{DS}$ pour quelques valeurs de la tension de commande $V_v$ = 0,4 V, 2,1 V et 5 V. L'examen de ces courbes montre qu'on peut obtenir une valeur de $Q_{ext}$ plus élevée en augmentant la tension de drain $V_{DS}$ sans modifier de façon significative la puissance de sortie de l'oscillateur.

## Revendications

1. Oscillateur hyperfréquence pour fournir à sa sortie avec une puissance utile une onde modulée linéairement en fréquence autour d'une fréquence centrale au moyen d'une diode à capacité variable (D1) en fonction d'une tension de commande appliquée aux bornes de ladite diode, ledit oscillateur comportant un transistor qui est d'un type de forte puissance (T) par rapport à la puissance utile et qui est muni d'électrodes d'entrée (G-S) et d'électrodes de sortie (D-S) (grille et source , et drain et source respectivement dans le cas où le transistor est à effet de champ) réunies par un réseau de rebouclage ($L_1$, $C_1$, $L_4$, $L_5$, $L_6$, $L_7$, $L_8$, $L_9$, $L_{10}$, $L_{11}$, $L_{12}$, $L_{13}$, $L_{14}$, $L_{21}$, $C_5$, $L_{22}$) comportant en outre un réseau de couplage ($L_5$ : $L_{27}$, $L_{25}$, $R_4$, $L_{26}$, $C_2$, $L_{28}$, $C_3$, $L_{29}$) pour fournir la puissance utile en prélevant une faible partie de la forte puissance, caractérisé en ce qu'une ligne (L27) du réseau de couplage est faiblement couplée par proximité à l'une des lignes (L5) de réseau de découplage et en ce que ledit transistor est un transistor présentant un gain tel que le réseau de rebouclage le porte à saturation quelle que soit la fréquence et en ce que ce réseau de rebouclage est conçu pour assurer un gain maximum à la fréquence centrale et pour réinjecter aux électrodes d'entrée du transistor la majeure partie de la forte puissance disponible aux électrodes de sortie.

2. Oscillateur selon la revendication 1, caractérisé en ce que le réseau de couplage est relié à une branche du réseau de rebouclage.

3. Oscillateur selon la revendication 2, caractérisé en ce que le réseau de couplage forme un coupleur directif avec ladite branche.

4. Oscillateur selon la revendication 1, caractérisé en ce que ladite diode à capacité variable et un condensateur fixe ($C_4$) sont intercalés en série entre trois éléments de ligne ($L_{15}$, $L_{16}$, $L_{17}$) dans un circuit de modulation monté en parallèle sur ledit réseau de rebouclage, une borne dudit condensateur étant reliée à un point du réseau de rebouclage à travers le premier élément de ligne ($L_{15}$) et l'autre borne à la cathode de la diode à travers le deuxième élément de ligne ($L_{16}$), l'anode de ligne de la diode étant reliée à une masse par l'intermédiaire du troisième élément de ligne ($L_{17}$), lesdits éléments de ligne étant déterminés pour optimiser la linéarité de la modulation de fréquence en fonction de ladite tension de commande.

## Claims

1. High-frequency oscillator for producing at its output with a useful power a wave linearly frequency-modulated around a centre frequency by means of a varicap diode ($D_1$) as a function of a control voltage applied to the terminals of said diode, said oscillator comprising a transistor of the high-power type (T) relative to the useful power and which comprises input electrodes (G-S) and output electrodes (D-S) (gate and source, and drain and source respectively, in the case where the transistor is a field effect transistor) connected by means of a feedback network ($L_1$, $C_1$, $L_4$, $L_5$, $L_6$, $L_7$, $L_8$, $L_9$, $L_{10}$, $L_{11}$, $L_{12}$, $L_{13}$, $L_{14}$, $L_{21}$, $C_5$, $L_{22}$) further comprising a coupling network ($L_5$ : $L_{27}$, $L_{25}$, $R_4$, $L_{26}$, $C_2$, $L_{28}$, $C_3$, $L_{29}$) for supplying the useful power while a small part of the high power is tapped, characterized in that a line ($L_{27}$) of the coupling network is slightly coupled by proximity to one of the lines ($L_5$) of the by-pass network, and in that said transistor is a transistor presenting such a gain that the feedback network brings this transistor to saturation whatever the frequency and in that this feedback network is arranged for ensuring a maximum gain at the centre frequency and for re-injecting into the input electrodes of the transistor the greater part of the high power available at the output electrodes.

2.  Oscillator as claimed in Claim 1, characterized in that the coupling network is connected to a branch of the feedback network.

3.  Oscillator as claimed in Claim 2, characterized in that the coupling network forms a directive coupler with said branch.

4.  Oscillator as claimed in Claim 1, characterized in that said varicap diode and a fixed capacitor ($C_4$) are arranged in series with three line elements ($L_{15}$, $L_{16}$, $L_{17}$) in a modulation circuit which is connected in parallel with said feedback network, a terminal of the capacitor being connected to a feedback network point *via* a first line element ($L_{15}$) and the other terminal being connected to the cathode of the diode *via* the second line element ($L_{16}$), the anode of the diode being connected to ground *via* the third line element ($L_{17}$), said line elements being determined to optimize the linearity of the frequency modulation as a function of said control voltage.

**Patentansprüche**

1.  HF-Oszillator zum an dessen Ausgang mit einer Nutzleistung Liefern einer um eine Zentralfrequenz herum liegenden linear frequenzmodulierten Welle mit Hilfe einer Varicap-Diode (D1) als Funktion einer Steuerspannung, die den Anschlüssen der genannten Diode zugeführt wird, wobei dieser Oszillator einen Transistor (T) mit einer gegenüber der Nutzleistung hohen Leistung aufweist, wobei dieser Transistor mit Eingangselektroden (G-S Gate und Source) und Ausgangselektroden (D-S Drain und Source in dem Fall, daß der Transistor ein Feldeffekttransistor ist) versehen ist, die zu einem Rückkopplungsnetzwerk vereint sind ($L_1$, $C_1$, $L_4$, $L_5$, $L_6$, $L_7$, $L_8$, $L_9$, $L_{10}$, $L_{11}$, $L_{12}$, $L_{13}$, $L_{14}$, $L_{21}$, $C_5$, $L_{22}$) mit außerdem einem Kopplungsnetzwerk ($L_5$ : $L_{27}$, $L_{25}$, $R_4$, $L_{26}$, $C_2$, $L_{28}$, $C_3$, $L_{29}$) zum Liefern einer Nutzleistung indem ein geringer Teil der hohen Leistung abgenommen wird, **dadurch gekennzeichnet, daß** eine Leitung ($L_{27}$) des Kopplungsnetzwerkes durch die Nähe einer der Leitungen ($L_5$) des Entkopplungsnetzwerkes schwach gekoppelt ist und daß der genannte Transistor ein Transistor ist, der eine derartige Verstärkung aufweist, daß das Rückkopplungsnetzwerk den Transistor in den gesättigten Zustand bringt, wie die Frequenz auch sein mag, und daß ds Rückkopplungsnetzwerk dazu konzipiert ist, bei der zentralen Frequenz eine maximale Verstärkung zu gewährleisten und zu den Eingangselektroden des Transistors den größten Teil der an den Ausgangselektroden verfügbaren hohen Leistung zurückzuführen.

2.  Oszillator nach Anspruch 1, **dadurch gekennzeichnet, daß** das Koppelnetzwerk mit einem Zweig des Rückkopplungsnetzwerkes verbunden ist.

3.  Oszillator nach Anspruch 2, **dadurch gekennzeichnet, daß** das Koppolnetzwerk mit dem genannten Zweig einen Richtkoppler bildet.

4.  Oszillator nach Anspruch 1, **dadurch gekennzeichnet, daß** die genannte Varicap-Diode und ein Festwertkondensator ($C_4$) zwischen drei Leitungselementen ($L_{15}$, $L_{16}$, $L_{17}$) in einer Modulationsschaltung reihengeschaltet sind, die zu dem genannten Rückkopplungsnetzwerk parallelgeschaltet ist, wobei der eine Anschluß des genannten Kondensators über ein erstes Leitungselement ($L_{15}$) mit einem Punkt des Rückkopplungsnetzwerkes verbunden ist und der andere Anschluß über das zweite Leitungselement ($L_{16}$) mit der Kathode der Diode verbunden ist, wobei die Anode der Diodenleitung über das dritte Leitungselement ($L_{17}$) mit Masse verbunden ist, wobei diese Leitungselemente dazu bestimmt sind, die Linearität der Frequenzmodulation als Funktion der genannten Steuerspannung zu optimieren.

FIG.1

FIG.2

FIG.3

FIG.4

# FIG.5